# EUROPEAN PATENT APPLICATION

(11) **EP 4 394 078 A1**
(43) Date of publication of application: **03.07.2024**
(21) Application number: 23216873.2
(22) Date of filing: 14.12.2023
(51) Int. Cl.: C23C 14/04

(54) **MASK AND METHOD FOR MANUFACTURING THE SAME**

(30) Priority: 26.12.2022 KR 20220184866
(71) Applicant: Samsung Display Co., Ltd., Gyeonggi-Do (KR); Olum Material Corporation, Gyeonggi-do (KR)
(72) Inventor: AHN, Hong-Kyun, Yongin-si (KR); LEE, Byoung-Il, Yongin-si (KR); JANG, Taekyong, Yongin-si (KR); KO, Jungwoo, Yongin-si (KR); LEE, Seungjin, Yongin-si (KR)
(74) Representative: Marks & Clerk LLP

(57) **Abstract**

A mask includes a mask frame having an opening, an open mask disposed on the mask frame, the open mask having a first opening, the first opening disposed in the opening in the case that it is viewed in a plan view, and a cell mask disposed on the open mask and having a second opening, the second opening being smaller than the first opening.

## Description

### BACKGROUND

### 1. Technical Field

Embodiments of the disclosure described herein relate to a mask and a method for manufacturing the same.

### 2. Description of the Related Art

In general, an electronic device, such as a smart phone, a digital camera, a laptop computer, a navigation device, or a smart television, which provides an image to a user includes a display device to display the image. The display device generates an image and provides the generated image to the user through a display screen.

The display device includes light emitting elements to generate light. Each of the light emitting elements includes an anode, a light emitting layer, and a cathode. As holes and electrons may be injected into the light emitting layer from the anode and the cathode, respectively, excitons may be formed. The excitons transit to the ground state, so the light emitting element emits light.

In the case that the light emitting elements are manufactured, masks may be disposed on a substrate, and organic materials may be provided on the substrate to form light emitting layers through openings of the mask. The cathode serves as a common layer, and the light emitting elements share the cathode together.

In the case that the cathode is formed, an additional mask may be used, in addition to the mask used to form the light emitting layers. In the case that the cathode is formed, a mask, which may be defined therein with an opening corresponding to a region for depositing the cathode, may be disposed on the substrate, and a conductive material for forming the cathode may be provided to the substrate through the opening of the mask.

### SUMMARY

Embodiments of the disclosure provide a mask capable of reducing a non-display region of a substrate by depositing a common layer, and a method for manufacturing the same.

According to an embodiment, a mask includes a mask frame having an opening, an open mask disposed on the mask frame, the open mask having at least one first opening, the at least one first opening overlapping the opening in a plan view, and at least one cell mask disposed on the open mask the at least one cell mask having at least one second opening, the at least one second opening being smaller than the at least one first opening.

The at least one second opening may overlap the at least one first opening in the plan view.

The open mask and the at least one cell mask may include a same material.

The open mask and the at least one cell mask may include Invar, stainless steel, or a combination thereof.

The at least one cell mask may have a thickness smaller than that of the open mask, and the open mask may have a thickness smaller than that of the mask frame.

The thickness of the at least one cell mask may be in a range of about 10 µm to about 50 µm, and the thickness of the open mask may be in a range of about 100 µm to about 150 µm.

An area of a portion of the at least one cell mask that overlaps the open mask may be smaller than an area of a portion of the at least one cell mask that overlaps the at least one first opening.

A ratio of an area of a portion of the at least one cell mask that overlaps the open mask to a total area of the at least one cell mask may be in a range of about 1/3 to about 1/4.

The at least one cell mask may include a plurality of first extending parts extending in parallel to each other in a first direction, and a plurality of second extending parts extending in a second direction intersecting the first direction to define the second opening together with the first extending parts, wherein in the second direction, a ratio of a width of a portion of the each of the first extending parts that overlaps the open mask to a total width of each of the first extending parts may be in a range of about 1/3 to about 1/4.

In the first direction, a ratio of a width of a portion of each of the second extending parts that overlaps the open mask to a total width of each of the second extending parts may be in a range of about 1/3 to about 1/4.

The at least one second opening may have an area larger than an area of a display region of a substrate disposed on the at least one cell mask, and the display region may overlap the at least one second opening in the plan view.

A distance in the second direction between a portion of an inner side surface of the at least one cell mask that extends in the first direction and defines the at least one second opening and a portion of an edge of the display region that extends in the first direction may be in a range of about 10 µm to about 20 µm.

A distance in the first direction between a portion of the inner side surface of the at least one cell mask that extends in the second direction and a portion of an edge of the display region that extends in the second direction may be in a range of about 10 µm to about 20 µm.

The at least one first opening may include a plurality of first openings, the at least one cell mask may include a plurality of cell masks, and each of the plurality of cell masks may be disposed to overlap a corresponding one of the plurality of first openings.

The at least one first opening may include a plurality of first openings, the at least one cell mask may include a plurality of cell masks, and the at least one second opening may include 'h' number of second openings defined in each of the plurality of cell masks, each of the plurality of cell masks may be disposed to overlap a corresponding 'h' number of the plurality of first openings, the 'h' number of second openings in the each of the plurality of cell masks may be disposed to overlap the corresponding 'h'number of the plurality of first openings, respectively, and 'h' may be a natural number equal to or greater than '2'.

The at least one first opening may include a plurality of first openings arranged in a plurality of rows and in a plurality of columns, the at least one cell mask may include a plurality of cell masks, and the at least one second opening may include a plurality of second openings defined in each of the plurality of cell masks, each of the plurality of cell masks may be disposed to overlap ones of the plurality of first openings disposed in a k-th row, and the plurality of second openings disposed in the each of the plurality of cell masks may overlap ones of the plurality of first openings disposed in the k-th row, respectively, and 'k' may be a natural number.

The at least one first opening may include a plurality of first openings arranged in a plurality of rows and in a plurality of columns, the at least one cell mask may include a plurality of cell masks, and the at least one second opening may include a plurality of second openings defined in each of the plurality of cell masks, each of the plurality of cell masks may be disposed to overlap ones of the plurality of first openings disposed in a j-th column, and the plurality of second openings disposed in the each of the plurality of cell masks may overlap the ones of the plurality of first openings disposed in the j-th column, respectively, and 'j' may be a natural number.

According to an embodiment, a mask may include a mask frame including an opening, an open mask disposed on the mask frame, the open mask may include a plurality of first openings, and a plurality of cell masks disposed on the open mask and overlapping the plurality of first openings, respectively, each of the cell masks may include a second opening, wherein the second opening of each of the plurality of cell masks may overlap a corresponding one of the plurality of first openings in a plan view.

According to an embodiment, a method for manufacturing a mask may include preparing a mask frame having an opening, disposing an open mask onto the mask frame while stretching the open mask, the open mask may include a first opening, coupling the open mask onto a top surface of the mask frame, and coupling a cell mask including a second opening onto a top surface of the open mask, wherein the second opening may be smaller than the first opening and may overlap first opening in a plan view.

The cell mask may be coupled to the open mask absent of being stretched.

At least some of the above and other features of the invention are set out in the claims.

### BRIEF DESCRIPTION OF THE FIGURES

An additional appreciation according to the embodiments of the disclosure will become more apparent by describing in detail the embodiments thereof with reference to the accompanying drawings, wherein:
FIG. 1 is an exploded perspective view of a mask according to an embodiment of the disclosure;
FIGS. 2 to 6 are views schematically illustrating the manufacturing process of a mask illustrated in FIG. 1;
FIG. 7 is a partial enlarged view illustrating one cell mask illustrated in FIG. 6, and an open mask overlapping the cell mask;
FIG. 8 is a plan view illustrating a configuration of a mother substrate used in the manufacturing process of a display panel;
FIG. 9 is a schematic cross-sectional view taken along line I-I' of FIG. 5;
FIG. 10 is a plan view of a display panel which is manufactured using a mask illustrated in FIG. 1;
FIG. 11 is a schematic cross-sectional view illustrating the configuration of any one pixel illustrated in FIG. 10;
FIG. 12 is a schematic cross-sectional view illustrating a portion of a display panel adjacent to an edge of a display region in FIG. 10;
FIG. 13 is a view illustrating the combination of a plan view illustrated FIG. 7 and any one display region of the mother substrate illustrated in FIG. 8;
FIG. 14 is a schematic cross-sectional view taken along line II-II' of FIG. 13;
FIG. 15A is a view illustrating an open mask according to an embodiment;
FIG. 15B is a view illustrating an open mask according to an embodiment;
FIG. 16 is a schematic cross-sectional view taken along line III-III' of FIG. 15B; and
FIGS. 17 to 20 are views illustrating the configuration of cell masks according to various embodiments of the disclosure.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in an embodiment.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be predisposed differently from the described order. For example, two consecutively described processes may be predisposed substantially at the same time or predisposed in an order opposite to the described order. Also, like reference numerals and/or reference characters denote like elements.

When an element, such as a layer, is referred to as being "on," "connected to," or "electrically connected to" another element or layer, it may be directly on, connected to, or electrically connected to the other element or layer or intervening elements or layers may be present. When, however, an element or layer is referred to as being "directly on," "directly connected to," or "directly electrically connected to" another element or layer, there are no intervening elements or layers present. To this end, the term "connected" may refer to physical, electrical, and/or fluid connection, with or without intervening elements. Also, when an element is referred to as being "in contact" or "contacted" or the like to another element, the element may be in "electrical contact" or in "physical contact" with another element; or in "indirect contact" or in "direct contact" with another element. Further, the X-axis, the Y-axis, and the Z-axis may not be limited to three axes of a rectangular coordinate system, such as the x, y, and z axes, and may be interpreted in a broader sense. For example, the X-axis, the Y-axis, and the Z-axis may be perpendicular to one another, or may represent different directions that may not be perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items. A description that a component is "configured to" perform a specified operation may be defined as a case where the component is constructed and arranged with structural features that can cause the component to perform the specified operation.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, may not be necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be disposed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, portion, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein. Hereinafter, embodiments of the disclosure will be described with reference to accompanying drawings.

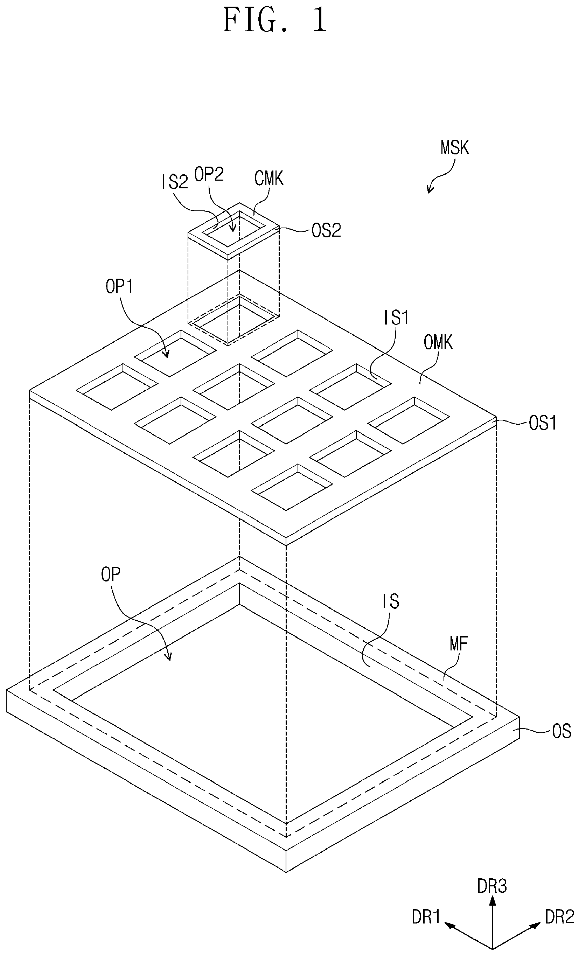

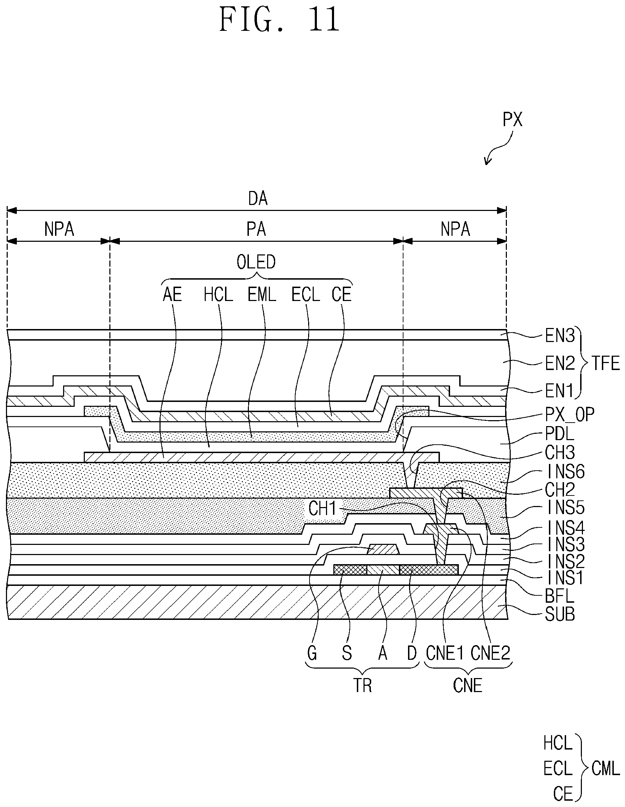

FIG. 1 is an exploded perspective view of a mask according to an embodiment of the disclosure. Referring to FIG. 1, a mask MSK according to an embodiment of the disclosure may include a mask frame MF, an open mask OMK, and multiple cell masks CMK. The mask MSK may be used to form a common layer of light emitting elements of a display device. The common layer may include an electron control layer, a hole control layer, and a cathode of the light emitting element, and the common layer will be described in detail below with reference to the schematic cross-section view of the light emitting element illustrated in FIG. 11.

The mask frame MF may have a rectangular frame shape having longer sides extending in a first direction DR1 and shorter sides extending in a second direction DR2 crossing the first direction DR1, but the shape of the mask frame MF may not be limited thereto. Hereinafter, a direction crossing a plane defined by the first and second directions DR1 and DR2 may be defined as a third direction DR3. The third direction DR3 may be substantially perpendicular to a plane defined by the first and second directions DR1 and DR2. In the specification, the meaning of "when viewed in a plan view" may refer to "when viewed in the third direction DR3 ".

An opening OP is defined in the mask frame MF, depending on a frame shape of the mask frame MF. In the case that it is viewed in a plan view, the opening OP may have a rectangular shape, but the shape of the opening OP may not be limited thereto.

Side surfaces, which face the outside of the mask frame MF may include side surfaces extending in the first direction DR1 and side surfaces extending in the second direction DR2. The side surfaces which face the outside of the mask frame MF may be defined as outer side surfaces OS. The outer side surface OS of the mask frame MF may be defined as an edge of the mask frame MF. Inner side surfaces IS of the mask frame MF may be defined by a side surface opposite to the outer side surfaces OS of the mask frame MF. The opening OP may be defined by the inner side surface IS of the mask frame MF. The mask frame MF may include a metal material. For example, the mask frame MF may include Invar, stainless steel, or a combination thereof.

The open mask OMK is disposed on the mask frame MF. The open mask OMK may have the plane defined by the first and second directions DR1 and DR2. The open mask OMK may have a rectangular frame shape having longer sides extending in the first direction DR1 and shorter sides extending in the second direction DR2, but the shape of the open mask OMK may not be limited thereto.

Multiple first openings OP1 may be defined in the open mask OMK. The first openings OP1 may be arranged in the first direction DR1 and the second direction DR2. The first openings OP1 overlap the opening OP in the case that they are viewed in a plan view. The first openings OP1 may have a rectangular shape extending with a longer length in the second direction DR2, but the shape of the first openings OP1 may not be limited thereto. For example, FIG. 1 shows twelve first openings OP1 arranged in three rows and four columns, but the quantity and arrangement of the openings may not be limited thereto. The row may correspond to the first direction DR1, and the column may correspond to the second direction DR2.

Side surfaces which face the outside of the open mask OMK may include side surfaces extending in the first direction DR1 and side surfaces extending in the second direction DR2. The side surfaces which face the outside of the open mask OMK may be defined as a first outer side surface OS1. The first outer side surface OS1 of the open mask OMK may be defined as an edge or periphery of the open mask OMK. The surfaces of the open mask OMK defining the first openings OP1 may be defined as first inner side surfaces IS1 of the open mask OMK.

The open mask OMK may have a thickness thinner than a thickness of the mask frame MF in the case that it is viewed in the third direction DR3. For example, the open mask OMK may have a thickness in a range of about 100 µm to about 150 µm. The open mask OMK may include a same material as the mask frame MF. For example, the open mask OMK may include a metal material. In detail, the open mask OMK may include Invar, stainless steel, or a combination thereof.

The open mask OMK may be welded to the mask frame MF. For example, a portion of the open mask OMK adjacent to a first outer side surface OS1 of the open mask OMK may be coupled to the mask frame MF by laser welding. The open mask OMK may be supported by the mask frame MF.

The cell masks CMK are disposed on the open mask OMK. The cell masks CMK may have a plane defined by the first and second directions DR1 and DR2. The cell masks CMK may have a rectangular frame shape having longer sides extending in the second direction DR2 and shorter sides extending in the first direction DR1, but the shape of the cell masks CMK may not be limited thereto. The cell masks CMK may be arranged in the first direction DR1 and the second direction DR2. The cell masks CMK may be prepared in number equal to the number of the first openings OP1 of open mask OMK. The cell masks CMK may be arranged in three rows and four columns to correspond to the first openings OP1. The cell masks CMK may be arranged to correspond to the first openings OP1, respectively. For example, each of the cell masks CMK may be disposed on a corresponding first opening OP1 of the open mask OMK. Accordingly, the cell masks CMK may be arranged to correspond to the first openings OP1 respectively in the case that they are viewed in a plan view.

A second opening OP2 is defined in each of the cell masks CMK. Accordingly, the second openings OP2 may be disposed to overlap the first openings OP1, respectively. The second openings OP2 may have a rectangular shape extending with a longer length in the second direction DR2, but the shape of the second openings OP2 may not be limited thereto.

Side surfaces OS2 which face the outside of the cell masks CMK may include side surfaces extending in the first direction DR1 and side surfaces extending in the second direction DR2. The side surfaces OS2 which face the outside of the cell masks CMK may be defined as a second outer side surface OS2. The second outer side surface OS2 of the cell masks CMK may be defined as an edge of each of the cell masks CMK. The second inner side surface IS2 of each of the cell masks CMK may be defined by a side surface opposite to the second outer side surface OS2 of each of the cell masks CMK. The second opening OP2 may be defined by the second inner side surface IS2 of each of the cell masks CMK.

Each cell mask CMK may have a thickness thinner than a thickness of the open mask OMK in the case that it is viewed in the third direction DR3. For example, each cell mask CMK may have the thickness in a range of about 10 µm to about 50 µm. The cell masks CMK may include a same material as the open mask OMK. For example, the cell masks CMK may include a metal material. In detail, the cell masks CMK may include Invar, stainless steel, or a combination thereof.

The cell masks CMK may be welded to the open mask OMK. For example, portions of the cell masks CMK adjacent to the edges of the cell masks CMK may be coupled to the open mask OMK by laser welding. However, the disclosure may not be limited thereto, and the cell masks CMK may instead be attached to the open mask OMK by an adhesive or a combination of welding and an adhesive. The cell masks CMK may be supported by the open mask OMK.

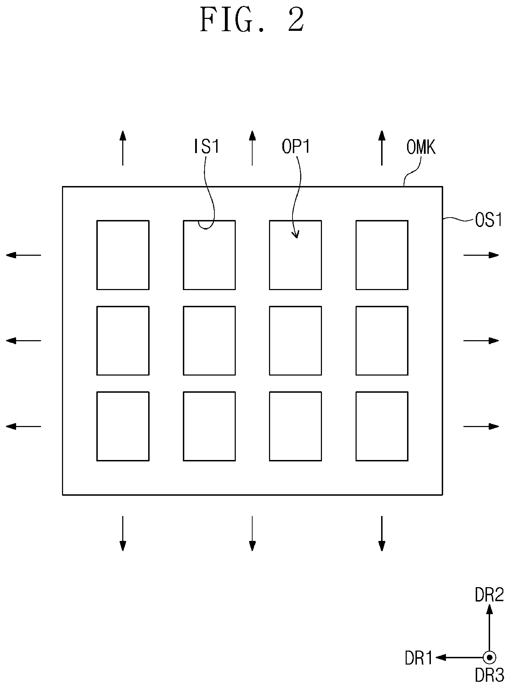

FIGS. 2 to 6 are views schematically illustrating the manufacturing process of the mask illustrated in FIG. 1. In the manufacturing process of the mask as illustrated in FIG. 2, the open mask OMK of FIG. 1 may be illustrated while being stretched. Referring to FIG. 2, the open mask OMK may be stretched before being coupled to the mask frame MF. In the case that the open mask OMK is disposed on the mask frame MF, the open mask OMK has a larger area and thus may sag down. To spread the open mask OMK to be flat, the open mask OMK may be stretched in the first direction DR1 and in the second direction DR2. Although not illustrated, a stretching structure that grips and stretches the edge of the open mask OMK may be used in the manufacturing process of the mask MSK.

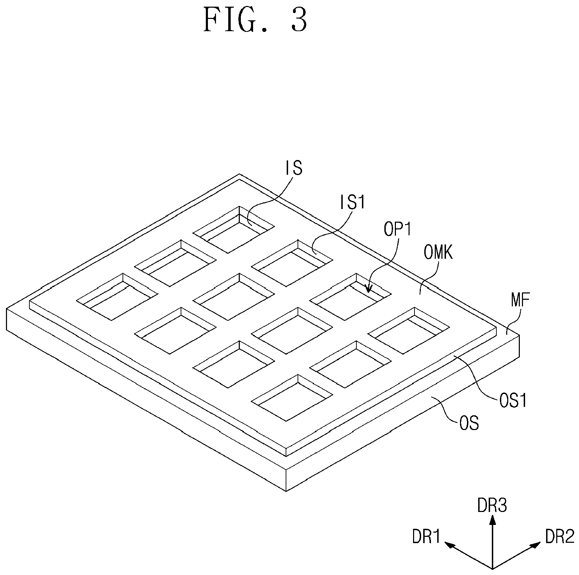

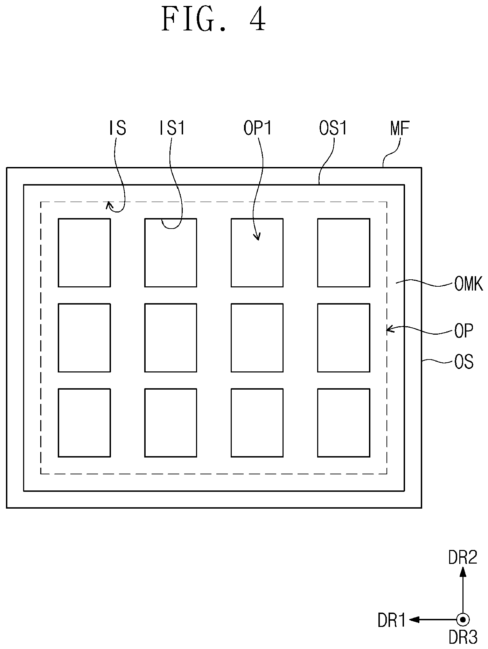

FIG. 3 is a view illustrating the state that the mask frame illustrated in FIG. 1 and the open mask may be coupled to each other. FIG. 4 is a plan view of the mask frame and the open mask illustrated in FIG. 3. FIG. 3 illustrates a perspective view, and the opening OP in FIG. 4 is illustrated in the form of a dotted line. Referring to FIGS. 1 and 3, the mask frame MF and the open mask OMK may be prepared, and the open mask OMK may be disposed on the top surface of mask frame MF. As illustrated in FIG. 2, after the open mask OMK is stretched, the open mask OMK may be coupled to the top surface of the mask frame MF.

As described above, the open mask OMK may be coupled to the top surface of the mask frame MF by laser welding. A portion of the open mask OMK which may be adjacent to the first outer side surface OS1 may be welded to the mask frame MF. The first outer side surface OS1 of the open mask OMK may be spaced apart from the outer side surface OS of the mask frame MF. In other words, the edge of the open mask OMK may be disposed at the inside of the edge of the mask frame MF.

Referring to FIGS. 1 and 4, in the case that it is viewed in a plan view, the first outer side surface OS1 of the open mask OMK may be interposed between the outer side surface OS and the inner side surface IS of the mask frame MF. A portion of the open mask OMK which may be adjacent to the first outer side surface OS1 of the open mask OMK may be disposed to overlap the mask frame MF in the case that it is viewed in a plan view. In the case that it they are viewed in a plan view, the first openings OP1 of the open mask OMK overlap the opening OP and may be disposed in the opening OP. In the case that they are viewed in a plan view, the first openings OP1 may be disposed at the inside of the inner side surface IS, such that the first openings OP1 may not overlap the mask frame MF.

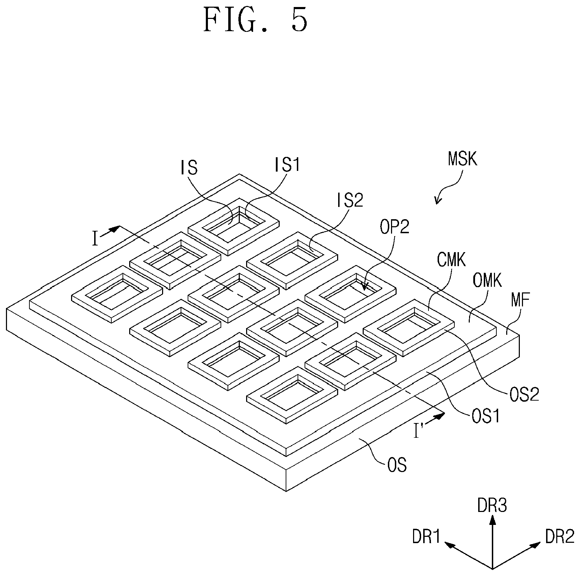

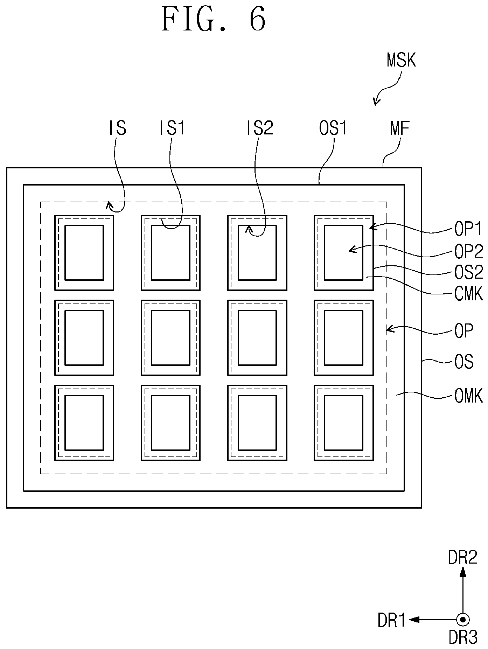

FIG. 5 is a view illustrating the state that the mask frame illustrated in FIG. 1, the open mask, and cell masks may be coupled to each other. FIG. 6 is a plan view of a mask frame, an open mask, and cell masks illustrated in FIG. 5. FIG. 5 illustrates a perspective view, and the opening OP and the first openings OP1 of FIG. 6 are illustrated in the form of a dotted line. Referring to FIGS. 1 and 5, the cell masks CMK may be prepared, and may be disposed on the top surface of the open mask OMK. The cell masks CMK may be arranged onto the first openings OP1, respectively. In the case that they are viewed in a plan view, the cell masks CMK may be arranged to overlap the first openings OP1, respectively. Accordingly, the second openings OP2 of the cell masks CMK may be disposed to overlap the first openings OP1, respectively.

As described above, the cell masks CMK may be welded to the top surface of the open mask OMK. Portions of the cell masks CMK which may be adjacent to the second outer side surfaces OS2 of the cell masks CMK may be welded to the open mask OMK. However, the disclosure may not be limited thereto, as portions of the cell masks CMK which may not be adjacent to the second outer side surfaces OS2 of the cell masks CMK may instead be coupled to the open mask OMK by an adhesive.

The open mask OMK having a larger area may be coupled to the mask frame MF through a welding process. However, the cell masks CMK significantly smaller than the open mask OMK may be readily attached to the open mask OMK by using an adhesive in addition to the welding process.

The open mask OMK may be stretched upon being coupled to the mask frame MF. Alternatively, the cell masks CMK may be coupled (e.g., directly coupled) to the open mask OMK without being stretched. Since the cell masks CMK are significantly smaller than the open mask OMK, the cell masks CMK may sag to a lesser degree. Accordingly, the cell masks CMK may be coupled to the open mask OMK without an additional stretching process. However, the disclosure may not be limited thereto, and the cell masks CMK may instead be stretched upon being coupled to the open mask OMK.

The cell masks CMK may be spaced apart from the first outer side surface OS1 of the open mask OMK. In other words, the cell masks CMK may be disposed at the inside of the edge of the open mask OMK. Referring to FIGS. 1 and 6, in the case that they are viewed in a plan view, the cell masks CMK may be disposed to overlap the opening OP of the mask frame MF. In the case that they are viewed in a plan view, the cell masks CMK may be disposed in the opening OP.

In the case that they are viewed in a plan view, the second openings OP2 of the cell masks CMK are smaller than the first openings OP1. The second openings OP2 may overlap the first openings OP1 and may be disposed inside the first openings OP1. In other words, each of the second openings OP2 may be disposed in a corresponding one of the first openings OP1.

In the case that they are viewed in a plan view, portions of the cell masks CMK adjacent to the second outer side surfaces OS2 of the cell masks CMK may be welded to the open mask OMK. Each of the first inner side surfaces IS1 of the open mask OMK may be interposed between the second inner side surface IS2 and the second outer side surface OS2 of a corresponding one of the cell masks CMK. In the case that they are viewed in a plan view, the second openings OP2 may be disposed at the inside of the first inner side surface IS1 of the open mask OMK, such that the second openings OP2 may not overlap the open mask OMK. As the mask frame MF, the open mask OMK, and the cell masks CMK may be coupled to each other, the mask MSK may be manufactured.

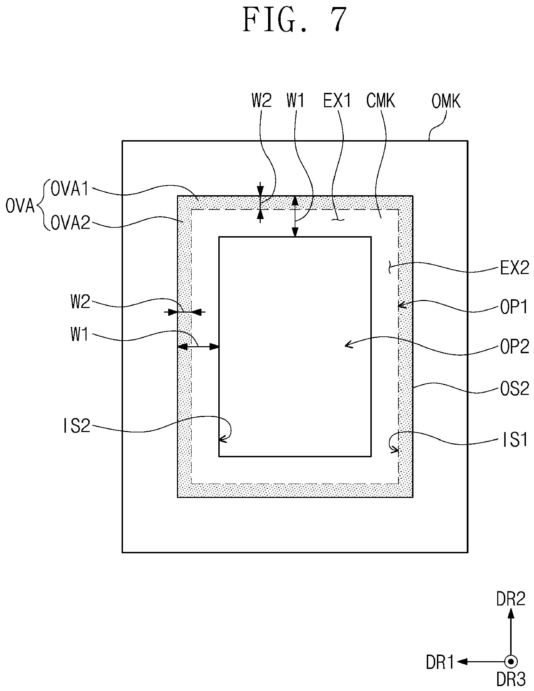

FIG. 7 is a partial enlarged view illustrating one cell mask illustrated in FIG. 6, and an open mask overlapping the cell mask. For example, although FIG. 7 illustrates that the first opening OP1 as a dotted line, a portion of the open mask OMK may have a rectangular shape.

Referring to FIG. 7, the first inner side surface IS1 of the open mask OMK may be interposed between the second inner side surface IS2 of the cell mask CMK and the second outer side surface OS2 of the cell mask CMK. As the second opening OP2 may be provided in the first opening OP1, a portion of the cell mask CMK may overlap the portion of the open mask OMK. More specifically, a portion of the cell mask CMK which may be adjacent to the second outer side surface OS2 of the cell mask CMK may overlap a portion of the open mask OMK which may be adjacent to the first opening OP1.

A portion of the cell mask CMK which overlaps the open mask OMK may have an area smaller than an area of a portion of the cell mask CMK which overlaps the first opening OP1. The portion of the cell mask CMK which overlaps the open mask OMK may be defined as an overlap region OVA. An area of the overlap region OVA may be in a range of about 1/2 to about 1/5 of the whole area of the cell mask CMK, and may be in a range of about 1/3 to about 1/4.

The cell mask CMK may include first extending parts EX1 extending in parallel to each other in the first direction DR1, and second extending parts EX2 extending in parallel to each other in the second direction DR2. The second extending parts EX2 may be longer than the first extending parts EX1. The second extending parts EX2 may extend from opposite ends of the first extending parts EX1, and may define the second opening OP2 together with the first extending parts EX1.

The first extending parts EX1 may each have a first width W1 in the second direction DR2. The second extending parts EX2 may each have the first width W1 in the first direction DR1. In other words, the first extending parts EX1 and the second extending parts EX2 may have equal widths. However, the disclosure may not be limited thereto. The first extending parts EX1 and the second extending parts EX2 may instead have mutually different widths.

The overlap region OVA may include first overlap regions OVA1 defined by portions of the first extending parts EX1 which overlap the open mask OMK, and second overlap regions OVA2 defined by portions of second extending parts EX2 which overlap the open mask OMK. Each of the first overlap regions OVA1 may have a second width W2 in the case that they are viewed in the second direction DR2. The second overlap regions OVA2 may have the second width W2 in the case that they are viewed in the first direction DR1. In other words, the first overlap regions OVA1 and the second overlap regions OVA2 may have equal widths. However, the disclosure may not be limited thereto. The first overlap regions OVA1 and the second overlap regions OVA2 may instead have mutually different widths. The second width W2 may be in a range of about 1/2 to about 1/5 of the first width W1, and may be in a range of about 1/3 to about 1/4.

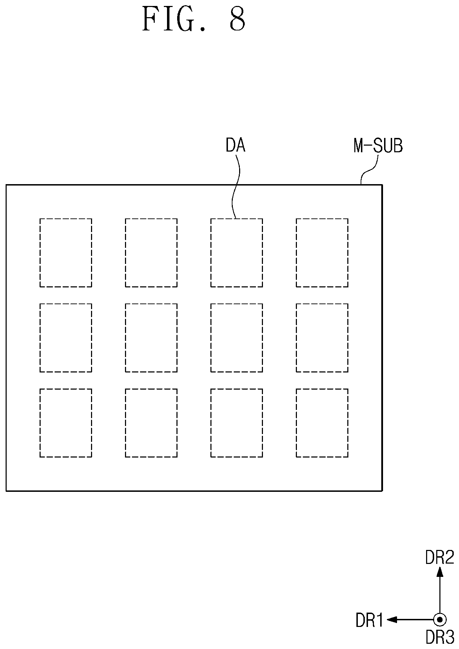

FIG. 8 is a plan view illustrating a configuration of a mother substrate used in the manufacturing process of a display panel. Referring to FIG. 8, in the case that a display device may be manufactured by using a mask MSK illustrated in FIG. 1, a mother substrate M-SUB may be prepared. Multiple display regions DA may be defined in the mother substrate M-SUB. The display regions DA may be arranged in the first direction DR1 and the second direction DR2. Pixels may be formed in each of the display regions DA.

The display regions DA may be disposed to correspond to the cell masks CMK illustrated in FIG. 6. In other words, the display regions DA may be prepared to have a number equal to the number of cell masks CMK and may be arranged in three rows and four columns. Each of the display regions DA may have a rectangular shape having longer sides extending in the second direction DR2 and shorter sides extending in the first direction DR1.

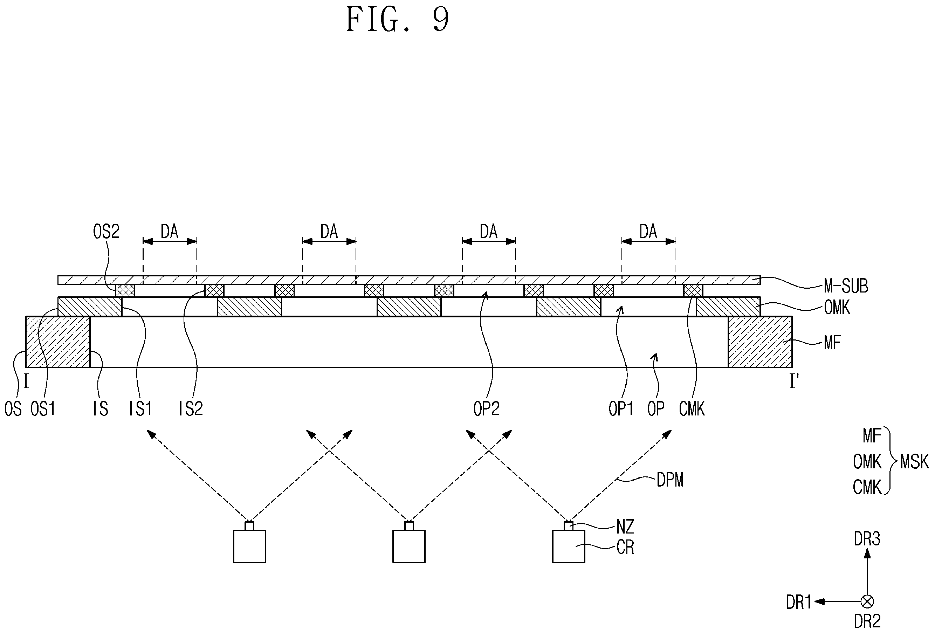

FIG. 9 is a schematic cross-sectional view taken along line I-I' of FIG. 5. FIG. 9 illustrates that the mother substrate M-SUB illustrated in FIG. 8 may be disposed on the mask MSK illustrated in FIG. 1. Specifically, FIG. 9 is a view illustrating a process of forming a common layer on the mother substrate M-SUB. Referring to FIG. 9, the mother substrate M-SUB may be disposed on the mask MSK. In detail, the open mask OMK may be disposed on the mask frame MF, the cell masks CMK may be disposed on the open mask OMK, and the mother substrate M-SUB may be disposed on the cell masks CMK. The display regions DA may be disposed on the cell masks CMK. The display regions DA may be arranged in the second openings OP2 defined in the cell masks CMK. In the case that they are viewed in a plan view, the display regions DA may overlap the second openings OP2. In the case that they are viewed in a plan view, each of the display regions DA may have an area smaller than an area of each of the second openings OP2. In the case that they are viewed in a plan view, the display regions DA may overlap the second openings OP2, respectively.

Crucibles CR may be disposed under the mask MSK. The crucibles CR may be disposed under the mask frame MF. Nozzles NZ may be disposed on the crucibles CR. A deposition material DPM may be received in each of the crucibles CR. Although not illustrated, a heat source to heat the crucibles CR may be disposed in the crucibles CR. Although not illustrated, the crucibles CR and the mask MSK may be disposed in a vacuum chamber used in the manufacturing process.

The crucibles CR may be heated, and the deposition material DPM may be vaporized and sprayed upward through the nozzles NZ. The vaporized deposition material DPM may be provided to the mother substrate M-SUB through the opening OP, the first openings OP1, and the second openings OP2. The deposition material DPM may include a material for forming the common layer.

As the deposition material DPM may be provided on a bottom surface of the mother substrate M-SUB, the common layer may be formed. The process may be defined as a deposition process. The deposition material DPM may be provided on the display regions DA. Accordingly, as the deposition material DPM may be provided on the display regions DA, the common layers may be formed in the display regions DA, respectively.

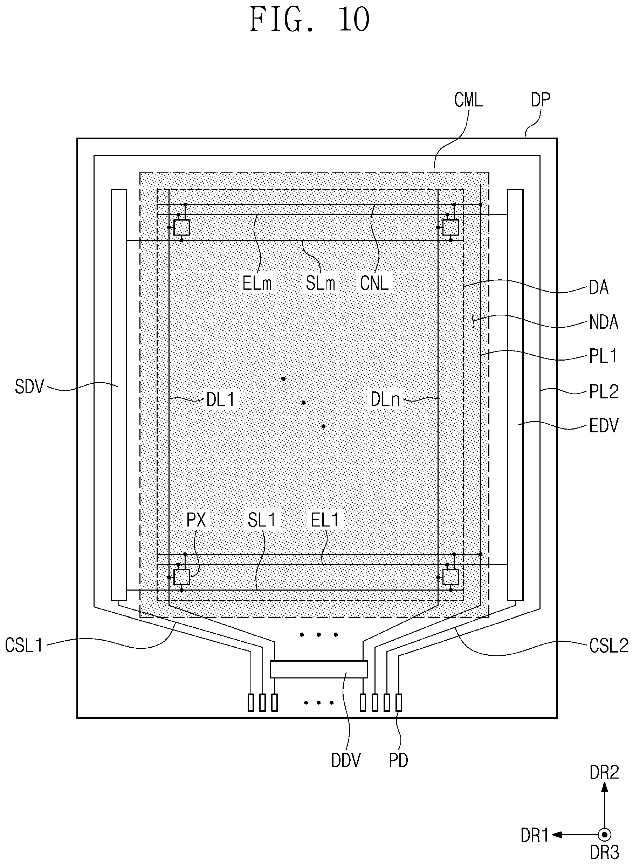

FIG. 10 is a plan view of a display panel which may be manufactured using a mask illustrated in FIG. 1. Referring to FIG. 10, a display panel DP may have a rectangular shape having longer sides extending in the second direction DR2 and shorter sides extending in the first direction DR1. However, the shape of the display panel DP may not be limited thereto. The display panel DP may include the display region DA and a non-display region NDA surrounding the display region DA. The display region DA may correspond to the display regions DA of the mother substrate M-SUB.

The display panel DP may be an emissive-display panel. The display panel DP may be an organic light emitting display panel or an inorganic light emitting display panel. The light emitting layer of the organic light emitting display panel may include an organic light emitting material. The light emitting layer of the inorganic light emitting display panel may include a quantum dot, or a quantum rod. Hereinafter, the display panel DP may be an organic light emitting display panel.

The display panel DP may include multiple pixels PX, multiple scan lines SL1 to SLm, multiple data lines DL1 to DLn, multiple light emitting lines EL1 to ELm, first and second control lines CSL1 and CSL2, first and second power supply lines PL1 and PL2, connecting lines CNL, and multiple pads PD where 'm' and 'n' may be natural numbers. The pixels PX may be manufactured on the display regions DA of the mother substrate M-SUB described above.

The pixels PX may be disposed in the display region DA. A scan driver SDV and a light emitting driver EDV may be disposed in the non-display region NDA adjacent to the longer sides of the display panel DP, respectively. A data driver DDV may be disposed in the non-display region NDA adjacent to one of the shorter sides of the display panel DP. In the case that it is viewed in a plan view, the data driver DDV may be adjacent to a bottom end of the display panel DP.

The scan lines SL1 to SLm may extend in the first direction DR1 so as to be electrically connected to the pixels PX and the scan driver SDV. The data lines DL1 to DLn may extend in the second direction DR2 to be electrically connected to the pixels PX and the data driver DDV. The light emitting lines EL1 to ELm may extend in the first direction DR1 to be electrically connected to pixels PX and the light emitting driver EDV.

The first power supply line PL1 may extend in the second direction DR2 and may be disposed in the non-display region NDA. The first power supply line PL1 may be interposed between the display region DA and the light emitting driver EDV, but may not be limited thereto. For example, the first power supply line PL1 may be interposed between the display region DA and the scan driver SDV.

The connecting lines CNL may extend in the first direction DR1 and may be arranged in the second direction DR2. The connecting lines CNL may be electrically connected to the first power supply line PL1 and the pixels PX. The first voltage may be applied to the pixels PX through the first power supply line PL1 and the connecting lines CNL that may be electrically connected to each other.

The second power supply line PL2 may be disposed in the non-display region NDA. The second power supply line PL2 may extend along the longer sides of the display panel DP and the other short side of the display panel DP at which the data driver DDV may not be disposed. The second power supply line PL2 may be disposed outside the scan driver SDV and the light emitting driver EDV. Although not illustrated, the second power supply line PL2 may extend toward the display region DA to be electrically connected to the pixels PX. A second voltage having a level lower than a first voltage may be applied to the pixels PX through the second power supply line PL2.

The first control line CSL1 may be electrically connected to the scan driver SDV and may extend toward the bottom end of the display panel DP in the case that it is viewed from above a plane. The second control line CSL2 may be electrically connected to the light emitting driver EDV and may extend toward the bottom end of the display panel DP in the case that it is viewed from above a plane. The data driver DDV may be interposed between the first control line CSL1 and the second control line CSL2.

The pads PD may be disposed on the display panel DP. The pads PD may be closer to the bottom end of the display panel DP rather than the data driver DDV. The data driver DDV, the first power supply line PL1, the second power supply line PL2, the first control line CSL1, and the second control line CSL2 may be electrically connected to the pads PD. The data lines DL1 to DLn may be electrically connected to the data driver DDV. The data driver DDV may be electrically connected to the pads PD corresponding to the data lines DL1 to DLn.

Although not illustrated, a timing controller for controlling operations of the scan driver SDV, the data driver DDV, and the light emitting driver EDV, and a voltage generator for generating first and second voltages may be disposed on a printed circuit board. The timing controller and the voltage generator may be electrically connected to the corresponding pads PD through a printed circuit board.

The scan driver SDV generates multiple scan signals, and the scan signals may be applied to the pixels PX through scan lines SL1 to SLm. The data driver DDV may generate multiple data voltages. The data voltages may be applied to the pixels PX through the data lines DL1 to DLn. The light emitting driver EDV may generate multiple light emitting signals, and the light emitting signals may be applied to the pixels PX through the light emitting lines EL1 to ELm.

The pixels PX may receive data voltages in response to the scan signals. The pixels PX may display the image by emitting light having brightness corresponding to data voltages, in response to the light emitting signals. The time to emit light by the pixels PX may be controlled through the light emitting signals.

The pixels PX may include a common layer CML. The pixels PX may share the common layer CML. The common layer CML may extend to the display region DA and a portion of the non-display region NDA which may be adjacent to the display region DA. For example, FIG. 10 illustrates that the common layer CML corresponds to a dotted-line box and having a gray color. The common layer CML may not extend to the scan drier SDV, the data driver DDV, and the light emitting driver EDV.

FIG. 11 is a schematic cross-sectional view illustrating the configuration of any one pixel of FIG. 10. Referring to FIG. 11, the pixels PX illustrated in FIG. 10 may have the same structure as that of the pixel PX illustrated in FIG. 11. The pixel PX may be disposed on a substrate SUB, and may include a transistor TR and a light emitting element OLED.

The light emitting element OLED may include an organic light emitting element. The light emitting element OLED may include a first electrode AE (or anode), a second electrode CE (or cathode), a hole control layer HCL, an electron control layer ECL, and a light emitting layer EML. The first electrode AE may be an anode electrode, and the second electrode CE may be a cathode electrode. The above-described common layer CML may include the hole control layer HCL, the electron control layer ECL, and the second electrode CE.

The transistor TR and the light emitting element OLED may be disposed on the substrate SUB. For example, although one transistor TR may be illustrated, the pixel PX may actually include multiple transistors to drive the light emitting element OLED and at least one capacitor.

The display region DA may include a light emitting region PA corresponding to the pixel PX and a non-light emitting region NPA in the vicinity of the light emitting region PA. The light emitting element OLED may be disposed in the light emitting region PA.

A buffer layer BFL may be disposed on the substrate SUB. The buffer layer BFL may be an inorganic layer. A semiconductor pattern may be disposed on the buffer layer BFL. For example, the semiconductor pattern may include polysilicon. However, the embodiment may not be limited thereto, and the semiconductor pattern may include amorphous silicon or a metal oxide.

The semiconductor pattern may be doped with an N-type dopant or a P-type dopant. The semiconductor pattern may include a heavily doped region and a lightly doped region. Conductivity of the heavily doped region may be greater than that of the lightly doped region. The heavily doped area may substantially operate as a source electrode or a drain electrode of the transistor TR. The lightly doped region may substantially correspond to an active (or a channel) of a transistor.

A source S, an active A, and a drain D of the transistor TR may be formed from the semiconductor pattern. A first insulating layer INS1 may be disposed on the semiconductor pattern. The gate G of the transistor TR may be disposed on the first insulating layer INS1. A second insulating layer INS2 may be disposed on the gate G. A third insulating layer INS3 may be disposed on the second insulating layer INS2.

A connection electrode CNE may be disposed between the transistor TR and the light emitting element OLED, to connect the transistor TR to the light emitting element OLED. The connection electrode CNE may include a first connection electrode CNE1 and a second connection electrode CNE2.

The first connection electrode CNE1 may be disposed on the third insulating layer INS3 and may be electrically connected to the drain D through a first contact hole CH1 defined in the first to third insulating layers INS1 to INS3. A fourth insulating layer INS4 may be disposed on the first connection electrode CNE1. A fifth insulating layer INS5 may be disposed on the fourth insulating layer INS4.

The second connection electrode CNE2 may be disposed on the fifth insulating layer INS5. The second connection electrode CNE2 may be electrically connected to the first connection electrode CNE1 through a second contact hole CH2 defined in the fifth insulating layer INS5 and the fourth insulating layer INS4. A sixth insulating layer INS6 may be disposed on the second connection electrode CNE2. The first to sixth insulating layers INS1 to INS6 may be inorganic layers or organic layers.

The first electrode AE may be disposed on the sixth insulating layer INS6. The first electrode AE may be electrically connected to the second connection electrode CNE2 through a third contact hole CH3 defined in the sixth insulating layer INS6. A pixel defining layer PDL may be disposed on the first electrode AE and the sixth insulating layer INS6 to expose a specific portion of the first electrode AE. The pixel defining layer PDL may have a pixel opening PX_OP defined therein to expose the specific portion of the first electrode AE.

The hole control layer HCL may be disposed on the first electrode AE and the pixel defining layer PDL. The hole control layer HCL may be commonly disposed in the light emitting region PA and the non-light emitting region NPA. Accordingly, the hole control layer HCL may be defined as the common layer CML. The hole control layer HCL may include a hole transport layer and a hole injection layer.

The light emitting layer EML may be disposed on the hole control layer HCL. The light emitting layer EML may be disposed in a region corresponding to the pixel opening PX_OP. Accordingly, the light emitting layer EML may be disposed to overlap the light emitting region PA. The light emitting layer EML may include an organic material. The light emitting layer EML may generate any one of a red color, a green color, and a blue color.

The electron control layer ECL may be disposed on the light emitting layer EML and the hole control layer HCL. The electron control layer ECL may be commonly disposed on the light emitting region PA and the non-light emitting region NPA. Accordingly, the electron control layer ECL may be defined as the common layer CML. The electron control layer ECL may include an electron transfer layer and an electron injection layer.

The second electrode CE may be disposed on the electron control layer ECL. The second electrode CE may be commonly disposed on the light emitting region PA and the non-light emitting region NPA. Accordingly, the second electrode CE may be defined as the common layer CML.

A thin film encapsulation layer TFE may be disposed on the light emitting element OLED. The thin film encapsulation layer TFE may be disposed on the second electrode CE to cover the pixel PX. The thin film encapsulation layer TFE may include a first thin film encapsulation layer EN1, a second thin film encapsulation layer EN2 on the first thin film encapsulation layer EN1, and a third thin film encapsulation layer EN3 on the second thin film encapsulation layer EN2.

The first and third thin film encapsulation layers EN1 and EN3 may include an inorganic layer and the second thin film encapsulation layer EN2 may include an organic layer. The first and third thin film encapsulation layers EN1 and EN2 may protect the pixel PX from moisture/oxygen. The second thin film encapsulation layer EN2 may protect the pixel PX from foreign substances such as dust particles.

The first voltage may be applied to the first electrode AE through the transistor TR, and a second voltage having a level lower than a level of the first voltage may be applied to the second electrode CE. Excitons may be formed by combining holes and electrons injected into the light emitting layer EML. As the excitons transition to a ground state, the light emitting device OLED may emit light.

Referring to FIGS. 9 and 11, the crucibles CR having a material received therein to form the hole control layer HCL of the common layer CML may be used. Crucibles CR having a material received therein to form the electron control layer ECL of the common layer CML may be used. Further, crucibles CR having a material received therein to form the second electrode CE of the common layer CML may be used. The hole control layer HCL, the electron control layer ECL, and the second electrode CE may be sequentially formed on the substrate.

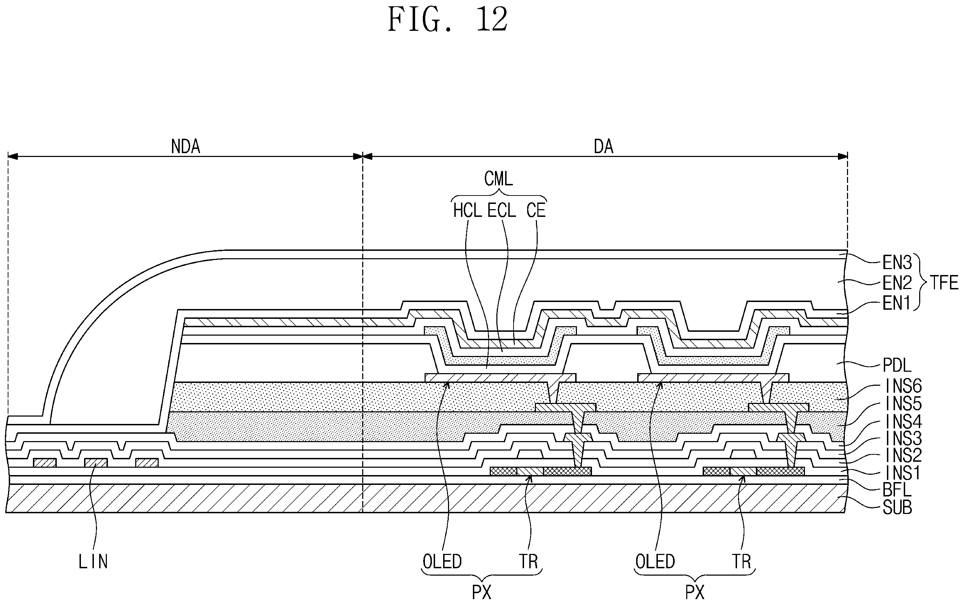

FIG. 12 is a schematic cross-sectional view illustrating a portion of the display panel adjacent to the edge of the display region of FIG. 10. Referring to FIGS. 11 and 12, the substrate SUB may include the display region DA and the non-display region NDA surrounding the display region DA which may be identical to the display panel DP. Pixels PX may be disposed in the display region DA of the substrate SUB.

The buffer layer BFL and the first to fourth insulating layers INS1 to INS4 may be disposed on the display region DA and the non-display region NDA. The fifth and sixth insulating layers INS5 and INS6 and the pixel defining layer PDL may be disposed on the display region DA and the non-display region NDA adjacent to the display region DA.

The first and third thin film encapsulation layers EN1 and EN3 may be disposed on the display region DA and the non-display region NDA. The first thin film encapsulation layer EN1 may be disposed on the pixels PX. The first thin film encapsulation layer EN1 may be disposed on the fourth insulating layer INS4 while covering the fifth and sixth insulating layers INS5 and INS6 and the edges of the pixel defining layer PDL, on the non-display region NDA.

The second thin film encapsulation layer EN2 may be disposed on the display region DA and a portion of the non-display region NDA adjacent to the display region DA. The second thin film encapsulation layer EN2 may be disposed on the non-display region NDA to cover the fifth and sixth insulating layers INS5 and INS6 and the pixel defining layer PDL. The third thin film encapsulation layer EN3 may be disposed on the non-display region NDA to cover the edge of the second thin film encapsulation layer EN2.

Multiple lines LIN may be disposed on the non-display region NDA. The lines LIN may indicate various lines such as data lines DL1 to DLn, light emitting lines EL1 to ELm, and the first and second control lines CSL1 and CLS2 extending to the non-display region NDA.

The hole control layer HCL, the electron control layer ECL, and the second electrode CE may be commonly disposed in the pixels PX. In other words, the common layer CML may be commonly disposed in the pixels PX. The common layer CML may be disposed on the display region DA, and may extend onto a portion of the non-display region NDA adjacent to the display region DA. The common layer CML may be disposed on the pixel defining layer PDL in the non-display region NDA.

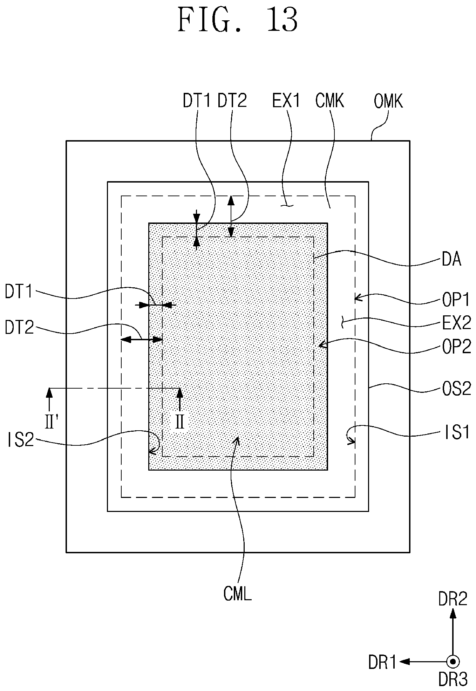

FIG. 13 is a view illustrating the combination of a plan view illustrated FIG. 7 and any one display region of the mother substrate illustrated in FIG. 8. For example, FIG. 13 is an enlarged view of FIG. 7. Referring to FIG. 13, in the case that it is viewed in a plan view, the display region DA may be disposed in the second opening OP2. Accordingly, the edge of the display region DA may be spaced apart from the second inner side surface IS2 defining the second opening OP2. The edge of the display region DA may have a longer distance to the first inner side surface IS1 rather than the distance to the second inner side surface IS2.

As illustrated in FIG. 9, the deposition material DPM passing through the second opening OP2 may be provided on a bottom surface of the mother substrate M-SUB. Accordingly, as illustrated in FIG. 13, the common layer CML may be formed in the region overlapping the second opening OP2. Accordingly, the common layer CML may be formed in the display region DA and a portion of non-display area NDA adjacent to the display region DA. For example, FIG. 13 illustrates that the common layer CML corresponds to the graycolored region. Since the mother substrate M-SUB may include the display regions DA, multiple common layers CML may be provided on the mother substrate M-SUB and disposed in the display regions DA.

The distance in the second direction DR2 between the second inner side surface IS2 extending in the first direction DR1 and the edge of the display region DA extending in the first direction DR1 may be defined as a first distance DT1. The distance in the first direction DR1 between the second inner side surface IS2 extending in the second direction DR2 and the edge of the display region DA extending in the second direction DR2 may be defined as the first distance DT1.

The distance in the second direction DR2 between the first inner side surface IS1 extending in the first direction DR1 and the edge of the display region DA extending in the first direction DR1 may be defined as a second distance DT2. The distance in the first direction DR1 between the first inner side surface IS1 extending in the second direction DR2 and the edge of the display region DA extending in the second direction DR2 may be defined as the second distance DT2.

The first distance DT1 may be smaller than the second distance DT2. For example, the first distance DT1 may be in a range of about 10 µm to about 50 µm, and may be in a range of about 10 µm to about 20 µm. For example, the second distance DT2 may be in a range of about 80 µm to about 100 µm.

A region for the common layer CML formed external to the display region DA may be defined as the non-display region NDA. In the case that only the open mask OMK may be used, since the deposition material DPM may be provided to the mother substrate M-SUB through the first opening OP1, the common layer CML may be formed to overlap the first opening OP1. A region for forming the common layer CML may be increased in portions of the non-display region NDA in a vicinity of the display region DA.

According to an embodiment of the disclosure, as the cell mask CMK having the second opening OP2 defined to be smaller than the first opening OP1 is used, the deposition material DPM may be provided to the mother substrate M-SUB through the second opening OP2. Accordingly, since the common layer CML may be formed to overlap the second opening OP2 that is smaller than the first opening OP1, the region for forming the common layer CML may be reduced in the vicinity of the display region DA. Since the region for forming the common layer CML may be decreased in the vicinity of the display region DA, the portion of the non-display region covered by the common layer CML may be decreased.

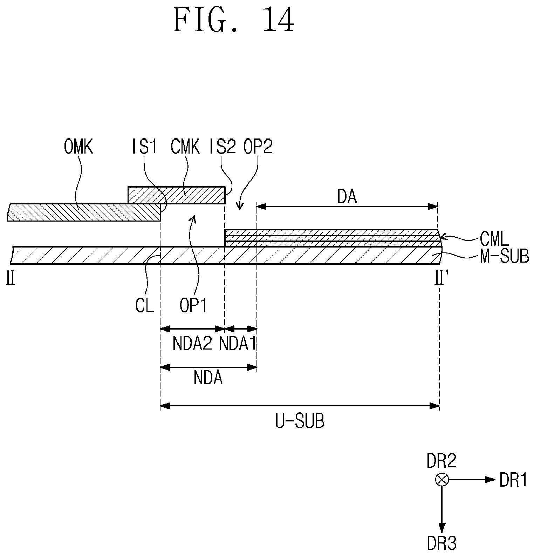

FIG. 14 is a schematic cross-sectional view taken along line II-II' of FIG. 13. Although FIG. 14 illustrates the common layer CML deposited on the mother substrate M-SUB, other components of the pixels PX may be omitted. Referring to FIGS. 8, 10, and 14, the mother substrate M-SUB may be cut to form an individual substrate U-SUB. In the case that it is viewed in a plan view, the region for the individual substrate U-SUB may be the same as the display panel DP. For example, as the mother substrate M-SUB may be cut along a cut line CL at a portion which may be adjacent to the display region DA of the mother substrate M-SUB, the individual substrate U-SUB may be formed. The individual substrate U-SUB may be the substrate SUB described above. Since the mother substrate M-SUB includes the display regions DA, the mother substrate M-SUB may be cut into multiple individual substrates U-SUB.

Referring to FIG. 14, the common layer CML may be disposed on the display region DA and may be provided onto a portion of the non-display region NDA adjacent to the display region DA. The non-display region NDA may include a first non-display region NDA1 in which the common layer CML may be disposed, and a second non-display region NDA2 adjacent to the first non-display region NDA1. The second non-display region NDA2 may be disposed at the outer portion of the first non-display region NDA1. The data driver DDV, the scan driver SDV, and the light emitting driver EDV (hereinafter, referred to as a driver) may be disposed on the second non-display region NDA2. In the display panel DP, the second non-display region NDA2 for disposing the driver should be ensured, in addition to the first non-display region NDA1 in which the common layer CML may be disposed.

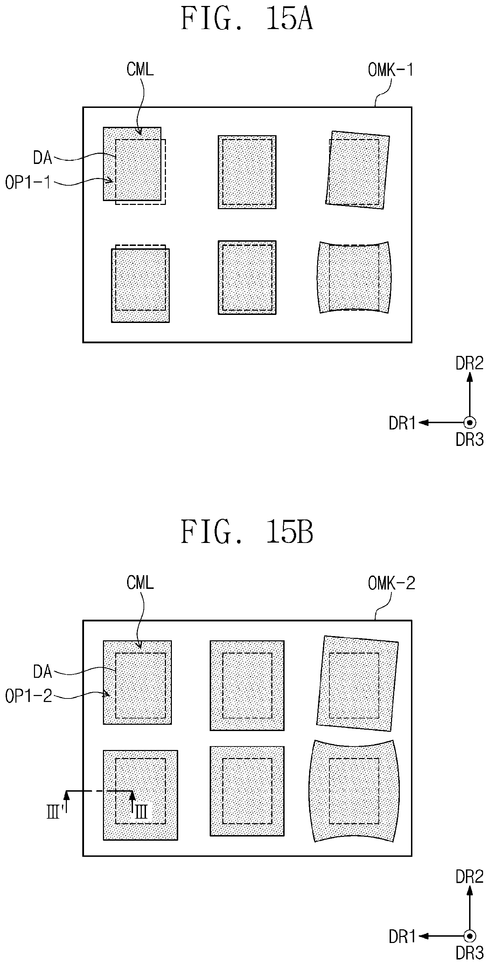

FIG. 15A is a view illustrating an open mask according to an embodiment. FIG. 15B is a view illustrating an open mask according to an embodiment. FIG. 15A and FIG. 15B illustrate some openings OP1-1 and OP1-2 of the open masks OMK-1 and OMK-2 respectively and display regions DA overlapping the some openings OP1-1 and OP1-2. Referring to FIG. 15A, in the case that the above-described cell masks CMK are not used, only the open mask OMK-1 is used, the deposition process of forming the above-described common layers CML may be performed. The first openings OP1-1 may be defined in the open mask OMK-1. The display regions DA may be arranged to correspond to the first openings OP1-1, respectively. The deposition materials DPM may be provided onto the mother substrate M-SUB through the first openings OP1-1.

Ideally, the common layers CML should be formed only in the display regions DA. However, the process of accurately forming the common layers CML only in the display regions DA may be difficult. In other words, although the deposition material DPM should be provided only to the display regions DA, but the process of accurately providing the deposition material DPM only to the display regions DA may be difficult. Therefore in case that considering the process margin, the first openings OP1-1 may be formed to be greater in size than the display regions DA instead of being exactly equal in size to the size of the display regions DA. Although the deposition material DPM may be provided up to the periphery of the display regions DA, the deposition material DPM may be provided even throughout the whole display regions DA. In other words, the common layers CML may be formed in portions of the non-display area NDA in the vicinity of the display regions DA, but may be sufficiently formed in the display regions DA.

Multiple first openings OP1-1 defined in the open mask OMK-1 may not be formed to have an equal size due to the process error. In the process of stretching the open mask OMK-1, the first openings OP1-1 may be misaligned or may be deformed depending on the tensile force. Some display regions DA may not be disposed entirely in some first openings OP1-1. Accordingly, the edges of some display regions DA may be external to first openings OP1-1. In the case that the deposition process may be performed, the common layers CML may not be formed in portions of some display regions DA.

Referring to FIG. 15B, the first openings OP1-2 may be defined in the open mask OMK-2. To prevent the problems described with reference to FIG. 15A, the first openings OP1-2 of the open mask OMK-2 may be sufficiently larger in size than the display regions DA. Although the alignment state may be similar to the state of the first openings OP1-1 as in FIG. 15A, the first openings OP1-2 have a sufficiently larger size. Accordingly, the display regions DA may be sufficiently disposed in the first openings OP1-2. Accordingly, the common layers CML may be sufficiently formed in the display regions DA.

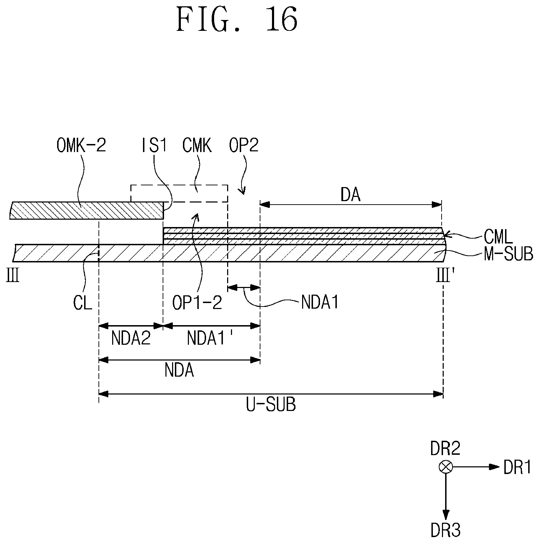

FIG. 16 is a schematic cross-sectional view taken along line III-III' illustrated in FIG. 15B. FIG. 16 illustrates the cell mask CMK as a dotted line based on the arrangement state of the cell mask. Referring to FIG. 16, in the case that the first opening OP1-2 may be increased, although the common layer CML may be sufficiently formed in the display regions DA, the region for the common layer CML may be expanded to a first extended non-display region NDA1' from the first non-display region NDA1.

Since the second non-display region NDA2 for forming the driver should be secured, in the case that the open mask OMK-2 is used, the non-display region NDA may be defined as the sum of the first extended non-display region NDA1' and the second non-display region NDA2. Accordingly, in the case that the open mask OMK-2 is used, the non-display region may be expanded.

Referring to FIG. 16, according to an embodiment of the disclosure, in the case that the cell mask CMK is disposed on the open mask OMK-2, the non-display region NDA may include the first non-display region NDA1 which is smaller than the first extended non-display region NDA1'. Accordingly, the non-display region NDA may be reduced.

The region between the edge of the display region DA and the first inner side surface IS1 of the open mask OMK-2 and the distance between the edge of the display region DA and the second inner side surface IS2 of the cell mask CMK may be defined as a tolerance region. The tolerance may be defined as an error officially allowed. In the case that the open mask OMK-2 only is used, the tolerance region may be expanded. However, in the case that the cell mask CMK is used, the tolerance region may be more precisely controlled such that the tolerance region may be reduced.

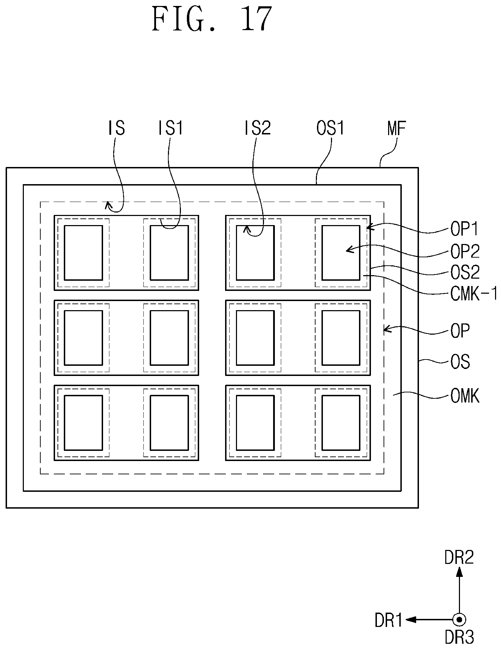

FIGS. 17 to 20 are views illustrating the configuration of cell masks according to various embodiments of the disclosure. FIGS. 17 to 20 illustrate plan views corresponding to FIG. 6. Hereinafter, the configurations of cell masks illustrated in FIGS. 17 to 20 will be described while focusing on the difference in configuration of the cell masks CMK illustrated in FIG. 6.

Referring to FIG. 17, each of cell masks CMK-1 may extend with a longer length in the first direction DR1 rather than the second direction DR2. Each of the cell masks CMK-1 may have 'h' number of second openings OP2 where "h" may be a natural number equal to or greater than 2.

The second openings OP2 of each of the cell masks CMK-1 may be arranged in the first direction DR1. Each of the cell masks CMK-1 may be disposed to overlap corresponding 'h' number of first openings OP1 of the first openings OP1 where 'h' number of first openings OP1 overlapping each of the cell masks CMK-1 may be arranged in the first direction DR1. Therefore, 'h' number of second openings OP2 in each of the cell masks CMK-1 may be disposed to overlap the corresponding 'h' number of first openings OP1, respectively.

In the configuration illustrated in FIG. 17, 'h' may be 2. In other words, two second openings OP2 may be defined in each of the cell masks CMK-1, and each of the cell masks CMK-1 may be disposed to overlap corresponding two first openings OP1. For example, two second openings OP2 in each of the cell masks CMK-1 may be disposed to overlap the corresponding two first openings OP1, respectively.

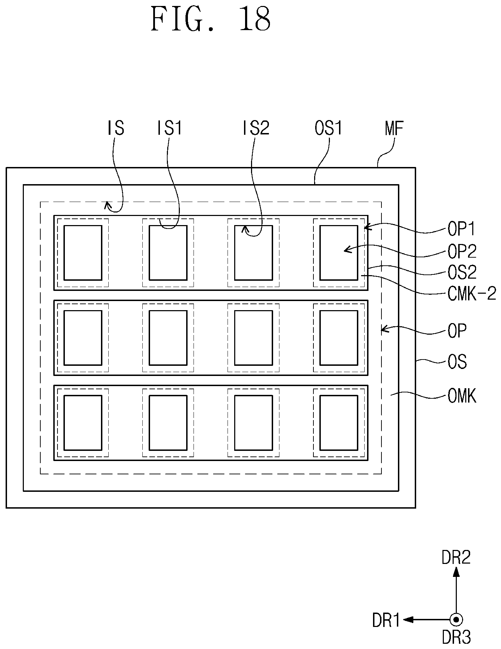

Referring to FIG. 18, the first openings OP1 may be arranged in multiple rows and multiple columns. Each of cell masks CMK-2 may extend with a longer length in the first direction DR1 rather than the second direction DR2. Each of the cell masks CMK-2 may have multiple second openings OP2 arranged in the first direction DR1. Each of the cell masks CMK-2 may be disposed to overlap the first openings OP1 in a k-th row where "k" may be a natural number. For example, the second openings OP2 in each of the cell masks CMK-2 may be disposed to overlap the first openings OP1 in the k-th row, respectively.

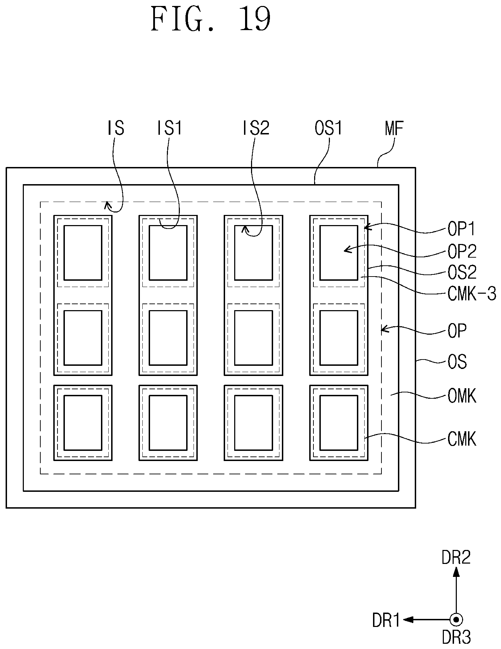

Referring to FIG. 19, the cell masks CMK and the cell masks CMK-3 may be disposed on the open mask OMK. The cell masks CMK-3 may be disposed to overlap to the corresponding first openings OP1, respectively. Each of cell masks CMK-3 may extend with a longer length in the second direction DR2 rather than the first direction DR1. Each of the cell masks CMK-3 may have 'h' number of second openings OP2 defined therein. In FIG. 19, 'h' may be 2 by way of example.

The second openings OP2 in each of cell masks CMK-3 may be arranged in the second direction DR2. Each of the cell masks CMK-3 may be disposed to overlap corresponding 'h' number of first openings OP1 of the first openings OP1 where 'h' number of first openings OP1 which overlaps each of the cell masks CMK-3 may be arranged in the second direction DR2. Therefore, 'h' number of second openings OP2 in each of the cell masks CMK-3 may be disposed to overlap the corresponding 'h' number of first openings OP1, respectively.

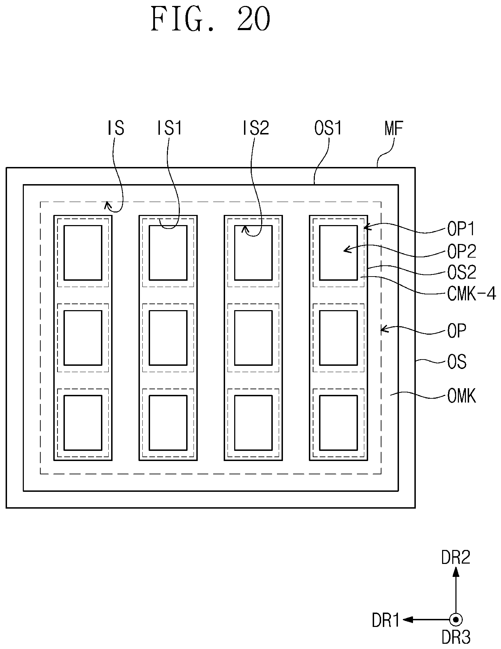

Referring to FIG. 20, each of cell masks CMK-4 may extend with a longer length in the second direction DR2 rather than the first direction DR1. Each of the cell masks CMK-4 may have multiple second openings OP2 defined therein and arranged in the second direction DR2. Each of the cell masks CMK-4 may be disposed to overlap the first openings OP1 in a j-th column where "j" may be a natural number. For example, the second openings OP2 in each of the cell masks CMK-4 may be disposed to overlap the first openings OP1 in the j-th column, respectively.

According to an embodiment of the disclosure, the first openings may be defined in the open mask, the cell masks may be disposed on the open mask, and the cell masks may overlap the first openings, respectively. The second openings having an area smaller than an area of the first openings may be defined in the cell masks, and the second openings may be disposed inside the first openings, in the case that they are viewed in a plan view.

In the case that the common layer may be deposited on the substrate, the common layer may be deposited on the substrate through the second openings smaller than the first openings. The common layer may be provided in the display regions of the substrate and at a portion of the non-display region of the substrate in the vicinity of the display regions. A portion of the substrate which may be in the vicinity of the display regions where the common layer is deposited may be defined as the non-display region. The common layer may be deposited in the portion of the non-display region of the substrate which may be adjacent to the display regions by using the second openings smaller than the first openings. Accordingly, the size of the portion of the non-display region that includes the common layer may be reduced.

Although described above with reference to an embodiment, it will be understood by those skilled in the art that various modifications and changes may be made in the disclosure without departing from the scope of the disclosure as set forth in the claims below. Furthermore, embodiments of the disclosure may not be intended to limit the technical idea of the disclosure. All technical ideas within the scope of the following claims and all equivalents thereof should be construed as being included within the scope of the disclosure.

While the disclosure has been described with reference to embodiments thereof, it will be apparent to those of ordinary skill in the art that various changes and modifications may be made thereto without departing from the scope of the disclosure as set forth in the following claims.

## Claims

1. A mask comprising:
a mask frame having an opening;
an open mask disposed on the mask frame, the open mask having at least one first opening, the at least one first opening overlapping the opening in a plan view; and
at least one cell mask disposed on the open mask, the at least one cell mask having at least one second opening, the at least one second opening being smaller than the at least one first opening.

2. The mask of claim 1, wherein the at least one second opening overlaps the at least one first opening in the plan view.

3. The mask of claim 1 or claim 2, wherein the open mask and the at least one cell mask include a same material, optionally wherein the open mask and the at least one cell mask include Invar, stainless steel, or a combination thereof.

4. The mask of any one of claims 1 to 3, wherein
the at least one cell mask has a thickness smaller than that of the open mask, and
the open mask has a thickness smaller than that of the mask frame.

5. The mask of claim 4, wherein
the thickness of the at least one cell mask is in a range of about 10 µm to about 50 µm, and
the thickness of the open mask is in a range of about 100 µm to about 150 µm.

6. The mask of any one of claims 1 to 5, wherein an area of a portion of the at least one cell mask that overlaps the open mask is smaller than an area of a portion of the at least one cell mask that overlaps the at least one first opening, optionally wherein a ratio of an area of a portion of the at least one cell mask that overlaps the open mask to a total area of the at least one cell mask is in a range of about 1/3 to about 1/4.

7. The mask of any one of claims 1 to 6, wherein the at least one cell mask includes:
a plurality of first extending parts extending in parallel to each other in a first direction; and
a plurality of second extending parts extending in a second direction intersecting the first direction to define the second opening together with the first extending parts, wherein
in the second direction, a ratio of a width of a portion of the each of the first extending parts that overlaps the open mask to a total width of each of the first extending parts is in a range of about 1/3 to about 1/4.

8. The mask of claim 7, wherein in the first direction, a ratio of a width of a portion of each of the second extending parts that overlaps the open mask to a total width of each of the second extending parts is in a range of about 1/3 to about 1/4.

9. The mask of claim 7 or claim 8, wherein
the at least one second opening has an area larger than an area of a display region of a substrate to be disposed on the at least one cell mask, and
the display region overlapping the at least one second opening in the plan view.

10. The mask of claim 9, wherein a distance in the second direction between a portion of an inner side surface of the at least one cell mask that extends in the first direction and defines the at least one second opening and a portion of an edge of the display region that extends in the first direction is in a range of about 10 µm to about 20 µm.

11. The mask of claim 10, wherein a distance in the first direction between a portion of the inner side surface of the at least one cell mask that extends in the second direction and a portion of the edge of the display region that extends in the second direction is in a range of about 10 µm to about 20 µm.

12. The mask of any one of claims 1 to 11, wherein
the at least one first opening includes a plurality of first openings,
the at least one cell mask includes a plurality of cell masks, and
each of the plurality of cell masks is disposed to overlap a corresponding one of the plurality of first openings.

13. The mask of any one of claims 1 to 11, wherein
the at least one first opening includes a plurality of first openings,
the at least one cell mask includes a plurality of cell masks, and the at least one second opening includes 'h' number of second openings defined in each of the plurality of cell masks,
each of the plurality of cell masks is disposed to overlap a corresponding 'h' number of the plurality of first openings,
the 'h' number of second openings in the each of the plurality of cell masks are disposed to overlap the corresponding 'h' number of the plurality of first openings, respectively, and
'h' is a natural number equal to or greater than '2'.

14. The mask of any one of claims 1 to 11, wherein
the at least one first opening includes a plurality of first openings arranged in a plurality of rows and in a plurality of columns,
the at least one cell mask includes a plurality of cell masks, and the at least one second opening includes a plurality of second openings defined in each of the plurality of cell masks,
each of the plurality of cell masks is disposed to overlap ones of the plurality of first openings disposed in a k-th row, and the plurality of second openings disposed in the each of the plurality of cell masks overlap ones of the plurality of first openings disposed in the k-th row, respectively, and
'k' is a natural number.

15. The mask of any one of claims 1 to 11, wherein
the at least one first opening includes a plurality of first openings arranged in a plurality of rows and in a plurality of columns,
the at least one cell mask includes a plurality of cell masks, and the at least one second opening includes a plurality of second openings defined in each of the plurality of cell masks,
each of the plurality of cell masks is disposed to overlap ones of the plurality of first openings disposed in a j-th column, and the plurality of second openings disposed in the each of the plurality of cell masks overlap the ones of the plurality of first openings disposed in the j-th column, respectively, and
'j' is a natural number.
